# FASCICULE DE BREVET EUROPEEN

(11) **EP 0 390 644 B1**
(45) Date de publication et mention de la délivrance du brevet: **27.04.1994**
(21) Numéro de dépôt: 90400761.4
(22) Date de dépôt: 20.03.1990
(51) Int. Cl.: G11C 19/28, G11C 27/04

(54) **Registres de lecture du type à transfert de charges à grande dynamique de sortie**
CCD-Ausleseschaltung mit einer grossen Ausgangsdynamik
CCD read-out circuit with a large dynamic output

(30) Priorité: 28.03.1989 FR 8903986
(43) Date de publication de la demande: 03.10.1990
(73) Titulaire: THOMSON-CSF SEMICONDUCTEURS SPECIFIQUES, 75008 Paris (FR)
(72) Inventeur: Cazaux, Yvon, F-92045 Paris La Défense (FR)
(74) Mandataire: Guérin, Michel

(56) Documents cités:
- EP-A- 0 192 142
- US-A- 4 554 675
- US-A- 4 603 426

## Description

L'invention s'applique aux registres de lecture constitués à l'aide d'un registre à décalage à transfert de charges (en anglais "Charges Coupled Device"), et comportant un étage de sortie monté au moins partiellement sur un même substrat semiconducteur que le registre à décalage. L'invention s'applique particulièrement dans le cas des registres à décalage fonctionnant en mode non biphasé, et elle concerne particulièrement des moyens destinés à obtenir une plus grande dynamique en amplitude du signal de sortie pour des tensions d'alimentations données.

De tels registres de lecture sont couramment utilisés dans des dispositifs de mémoire ou de lignes à retard, ou encore par exemple dans des capteurs photosensibles pour caméras.

Les dispositifs à transfert de charges sont des systèmes a semiconducteurs dans lesquels on stocke des charges dans des puits de potentiels et dans lesquels on transporte ces charges d'un point à un autre en les transférant d'un puits de potentiel à un puits de potentiel voisin, les charges occupant ainsi successivement tous les puits de potentiel entre la zone de départ et la zone d'arrivée de ces charges. En fait les charges circulent sensiblement à la surface du substrat semiconducteur ou éventuellement dans une couche de faible profondeur située à proximité de la surface (dispositif dit à "canal enterré").

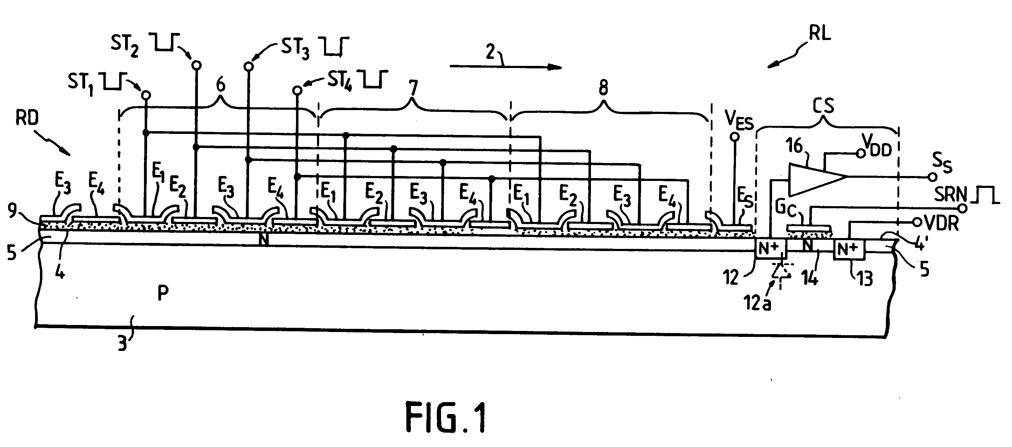

La figure 1 représente schématiquement et partiellement, un registre de lecture d'un type connu tel que ci-dessus cité. Ce registre de lecture est représenté par une vue en coupe parallèlement au sens de transfert des charges qui est symbolisé sur la figure par une flèche 2. Le registre de lecture est formé sur un substrat 3 dopé de type P par exemple. Ce substrat 3 peut comporter à proximité de sa surface 4, une couche 5 dopée de type N, en vue de constituer de façon classique un canal enterré. Le registre de lecture est formé par un registre à décalage RD suivi, dans le sens de transfert des charges par un circuit de sortie CS. Le registre à décalage comporte une pluralité d'étages de transferts successifs comportant chacun au moins trois électrodes. Pour plus de clarté de la figure 1, une succession de seulement trois étages de transferts 6, 7, 8 ont été représenté, le dernier étage de transferts 8 étant à proximité du circuit de sortie CS dont il est séparé par une électrode de sortie ES.

Dans l'exemple montré par la figure 1, le registre à décalage RD est du type fonctionnant en mode quatre phases de manière classique, c'est-à-dire que les étages de transferts 6, 7, 8 comportent chacun, suivant le sens de transfert des charges, une succession de quatre électrodes E1, E2, E3, E4 réalisées au-dessus du substrat 3. Plus précisément, ces électrodes ainsi que l'électrode de sortie ES sont réalisées au dessus d'une couche électriquement isolante 9 qui les sépare de la couche 5 dopée N. Les quatre électrodes E1 à E4 de chaque étage de transfert sont commandées par des impulsions de tensions cycliques ou signaux de transfert, ST1, ST2, ST3, ST4 ayant des phases différentes, de manière à engendrer sous ces électrodes des barrières de potentiels et des puits de potentiels pour transférer les charges vers le circuit de sortie CS ; les premier, seconde, troisième et quatrième signaux de transfert ST1, ST2, ST3, ST4 étant appliqués respectivement à toutes les première, seconde, troisième, quatrième électrodes E1, E2, E3, E4.

La quatrième électrode E4 de l'étage de transfert le plus proche du circuit de sortie CS c'est-à-dire le dernier étage de transfert 8, constitue la dernière électrode (selon le sens de transfert 2 des charges) du registre à décalage RD, et elle est suivie par l'électrode de sortie ES à laquelle est appliqué un potentiel VES continu par exemple, qui permet d'établir, sous l'électrode de sortie ES, une barrière de potentiel de séparation entre les potentiels créés sous le dernier étage de transfert 8 et un élément de stockage terminal des charges appartenant au circuit de sortie CS. Cet élément de stockage terminal des charges est représenté sur la figure par une zone 12 dopée de type N+ c'est-à-dire du même type que le canal enterré 5 mais davantage dopé que ce dernier ; cette zone N+ étant insérée dans le canal enterré 5.

En fait la jonction entre cette zone 12 dopée N+ et le substrat 3 qui est du type de conductivité opposée c'est-à-dire dopé P, réalise une diode 12a (symbolisée sur la figure en traits pointillés) appelée diode de lecture : quand cette diode 12a est polarisée en inverse, elle présente une capacité qui de manière classique assure le stockage des charges, et la diode de lecture 12a constitue ainsi l'élément de stockage terminal ci-dessus mentionné.

Toujours dans le sens 2 de transfert des charges, on trouve ensuite, au-dessus du substrat 3, une grille de commande GC qui elle même est suivie d'une seconde zone 13 dopée de type N+, c'est-à-dire du même type que le canal enterré 5 mais davantage que ce dernier, cette seconde zone 13 dopée N+ étant également insérée dans le canal enterré 5. En fait, la première zone 12 dopée N+ suivie d'une partie 14 de canal enterré au-dessus de laquelle est placée la grille de commande GC, et la seconde zone 13 dopée N+ forment un transistor de type MOS dont la zone 12 représente par exemple la source, la zone 13 représente le drain et l'électrode GC représente la grille de commande ; une tension d'alimentation VDR continue de par exemple +12 volts par rapport au potentiel du substrat 3, est appliquée à la seconde zone 13 ou drain, et d'autre part, une impulsion de remise à niveau SRN est appliquée à la grille de commande GC afin de commander la conduction du transistor MOS et par suite de porter la première zone 12 au potentiel de VDR : ceci à des instants bien déterminés, en dehors desquels le potentiel de la première zone 12 (et donc la diode de lecture 12a) est flottant et peut donc varier en fonction des charges accumulées. La diode de lecture 12a est reliée à l'entrée d'un amplificateur de sortie 16 qui reçoit une tension d'alimentation V_{DD}, et qui délivre un signal de sortie Ss dont la valeur est fonction de la quantité de charges présentes sur la diode de lecture 12a.

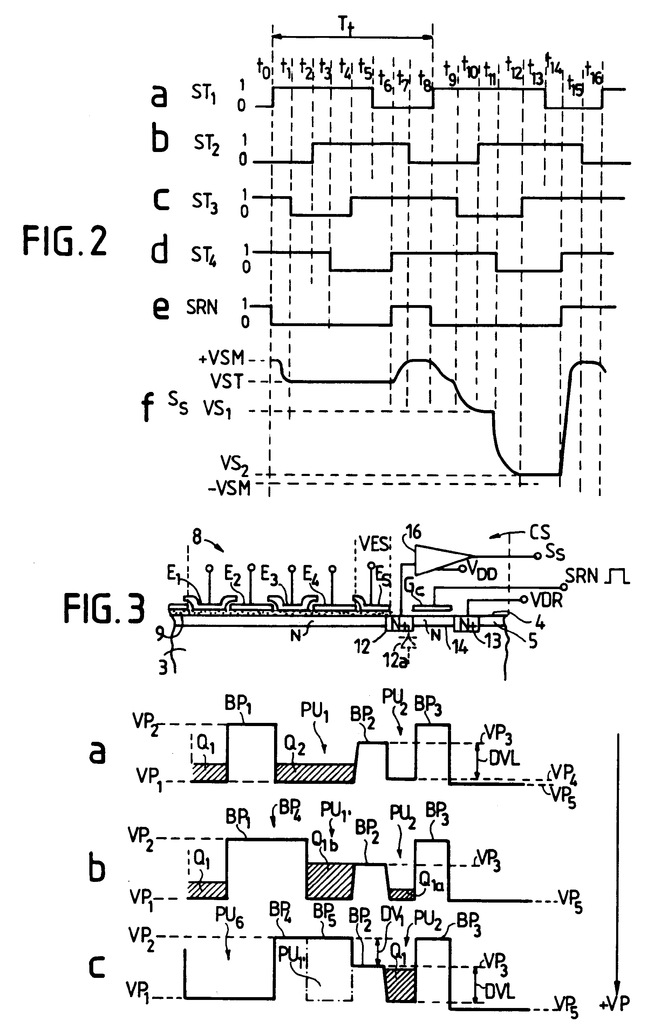

Les figures 2a à 2f illustrent les différences de phases entre les impulsions ou signaux de transfert ST1 à ST4, et la relation entre ces signaux et le signal de sortie Ss délivré par l'amplificateur de sortie 16.

Les signaux de transfert ST1 à ST4 sont représentés respectivement aux figures 2a à 2d. Ces signaux ont une même forme, une même fréquence, mais une phase différente, et peuvent comporter un état zéro ou un état 1, l'état 1 représentant un potentiel positif par rapport à l'état 0. La figure 2e représente les impulsions de remise à niveau SRn qui sont appliquées à la grille de commande GC : ces impulsions varient également entre un état zéro et un état 1 (positif par rapport à l'état zéro). La figure 2f illustre les variations d'amplitude de tension VS du signal de sortie Ss qui peut varier par exemple entre une valeur positive maximum +VSM correspondant à la valeur du potentiel de VDR et une valeur négative maximum -VSM qui correspond à une quantité de charges maximum sur la diode de lecture 12a.

A l'instant t0 : le premier signal de transfert ST1 qui est appliqué aux premières électrodes E1 passe de l'état zéro à l'état 1 ; le second signal de transfert ST2 appliqué aux secondes électrodes E2 est à l'état zéro ; le troisième signal de transfert ST3 appliqué aux troisièmes électrodes E3 est à l'état 1 ; le quatrième signal de transfert ST4 appliqué aux quatrièmes électrodes E4 est à l'état 1 ; l'impulsion de remise à niveau SRN appliqué à l'électrode de commande GC se termine et passe de l'état 1 à l'état zéro ; le signal de sortie Ss est à la valeur de +VSM, la diode de lecture ayant été reliée au potentiel VDR pendant la durée de l'impulsion de remise à niveau SRN.

Il est à noter qu'il n'est précisé ci-après que les états des signaux qui ont été modifiés par rapport aux instants précédemment mentionnés.

A l'instant t1, le troisième signal de transfert ST3 passe de l'état 1 à l'état zéro ; le signal de sortie Ss est passé à une valeur Vst inférieure à la valeur VSM, et qui représente une valeur de stabilisatlon après l'opération de remise à niveau ; la diode de lecture étant à partir de cet instant t1 en principe prête à recevoir des charges qui se traduiront par une modification du signal de sortie Ss en sortie de l'amplificateur de sortie 16. En supposant que dans la suite aucune charge ne soit transférée à la diode de lecture 12a, le signal de sortie Ss conserve sa valeur de stabilisation VST jusqu'à l'instant où débute un nouveau signal de remise à niveau SRN.

A l'instant t2 : le second signal de transfert ST2 passe de l'état zéro à l'état 1.

A l'instant t3 : le quatrième signal de transfert ST4 passe de l'état 1 à l'état zéro.

A l'instant t4 : le troisième signal de transfert ST3 passe de l'état zéro à l'état 1.

A l'instant t5 : le premier signal de transfert ST1 passe de l'état 1 à l'état zéro.

A l'instant t6 : le quatrième signal de transfert ST4 passe de l'état zéro à l'état 1 ; une nouvelle impulsion de remise à niveau débute, qui passe de l'état zéro à l'état 1 ; le signal de sortie Ss tend de la valeur VST vers la valeur VSM.

A l'instant t7 : le second signal de transfert ST2 passe de l'état 1 à l'état zéro ; et le signal de sortie Ss est à un niveau intermédiaire entre la valeur de stabilisation VST et la valeur maximum VSM.

A l'instant t8 : le premier signal de transfert ST1 passe de l'état zéro à l'état 1, et l'on observe que le temps entre l'instant t0 et l'instant t8 correspond à un cycle complet du premier signal de transfert ST1 et que ce temps correspond à un temps Tt de transfert des charges d'un étage à un étage suivant ; le signal de remise à niveau SRn s'achève et passe de l'état 1 à l'état zéro ; à cet instant t8, le signal de sortie Ss a retrouvé la valeur +VSM, par suite de la commande de remise à niveau, et tend vers la valeur de stabilisatlon VST.

A l'instant t9 : le troisième signal de transfert ST3 passe de l'état 1 à l'état 0. Il est à noter que ceci conduit à transférer sous l'électrode E4 les charges qui étaient stockées sous l'électrode E3. De sorte que si la quantité de charges qui étaient simultanément contenues sous l'électrode E3 et l'électrode E4 était importante, ce transfert a pour conséquence (comme il sera davantage expliqué en référence à la figure 3) de provoquer un transfert parasite d'une partie de ces charges vers la diode de lecture 12a, d'où il en résulte une variation négative du signal de sortie Ss qui passe à une valeur VS1 inférieure à la valeur VST de stabilisation.

Ceci met en évidence un des inconvénients importants de ce fonctionnement en mode 4 phases qui, par ailleurs, présente l'avantage d'assurer un bon transfert des charges du fait de la présence à l'état 1 (potentiel positif) d'au moins deux électrodes voisines. L'inconvénient qui vient d'être cité réside dans le fait que le fonctionnement qui vient d'être décrit conduit à une dissymétrie des durées, d'une part, du temps alloué à la remise à niveau de la diode de lecture, et d'autre part, du temps alloué à l'arrivée des charges au niveau de la diode de lecture, cet inconvénient étant particulièrement gênant dans le cas où la lecture du signal (correspondant aux charges transférées à la diode de lecture) est effectuée par une méthode de double échantillonnage ou lecture différentielle : dans ce cas en effet, la valeur du signal utile en sortie de l'amplificateur de sortie est donnée par la différence entre la valeur lue quand toutes les charges ont été transférées à la diode de lecture, et la valeur présente avant le transfert de ces charges, c'est-à-dire théoriquement quand le signal de sortie Ss a encore la valeur du potentiel de stabilisation VST, lequel dans ce cas a une durée très faible.

A l'instant t10, le second signal de transfert ST2 passe de l'état zéro à l'état 1.

A l'instant t11 : le signal de sortie Ss a la valeur VS1 ; le quatrième signal de transfert ST4 appliqué à toutes les quatrième électrodes E4 passe de l'état 1 à l'état zéro c'est-à-dire à un potentiel plus négatif que celui de l'état 1. En supposant que des charges aient été stockées sous la quatrième électrode E4 du premier étage de transfert, ces charges sont transférées à la diode de lecture 12a : ceci entraîne une variation négative du signal de sortie Ss qui passe de la valeur VS1 à une valeur VS2 plus faible que VS1 et voisine par exemple de la valeur négative maximum -VSM, et la différence entre ces deux valeurs représente la quantité de charges transférées à la diode de lecture 12a à partir de l'instant t11.

A l'instant t12 : le signal de sortie Ss a atteint la valeur VS2 ; le troisième signal de transfert ST3 passe de l'état zéro à l'état 1.

A l'instant t13 : le premier signal de transfert ST1 passe de l'état 1 à l'état zéro (comme précédemment à l'instant t5).

A l'instant t14 : on retrouve les mêmes signaux qu'à l'instant t6 : le quatrième signal de transfert ST4 appliqué aux quatrièmes électrodes E4 passe de l'état zéro à l'état 1 ; on trouve le début de l'impulsion de remise à niveau SRN, c'est-à-dire que le potentiel appliqué à l'électrode de commande GC passe de l'état zéro à l'état 1 ; on note une variation positive du signal de sortie Ss qui en partant de la valeur VS2 tend vers la valeur VSM qui est atteinte à l'instant t15.

A l'instant t16 : on retrouve les mêmes évènements qu'aux instants t0 et t8 et un même fonctionnement ensuite que celui qui vient d'être décrit.

La figure 3 représente le registre de lecture RL par une vue en coupe semblable à celle de la figure 1, mais dans laquelle pour simplifier la description, la représentation du registre à décalage RD est limitée au dernier étage de transfert 8, c'est-à-dire à l'étage de transfert le plus proche du circuit de sortie CS. Les figures 3a, 3b, 3c sont à lire avec la figure 3, et illustrent les profils de potentiels VP établis sous les différentes électrodes, grilles et au niveau de la diode de lecture 12a ; conformément à l'habitude en matière de dispositif à transfert de charges, les potentiels positifs vont en croissant vers le bas.

La figure 3a montre les potentiels VP établis dans le substrat entre l'instant t8 et l'instant t9. Durant cet intervalle de temps, les troisième et quatrième impulsions de transfert ST3, ST4 sont à l'état 1 (potentiel plus positif), de telle sorte que sous la troisième et la quatrième électrodes E3, E4 est créé un unique puits de potentiel PU1 dont la profondeur correspond à un potentiel VP1. La seconde impulsion de transfert ST2 est à cet instant à l'état zéro d'où il résulte, sous la seconde électrode E2 un potentiel VP2 négatif par rapport au potentiel VP1 établi sous les troisième et quatrième électrodes E3, E4, et qui constitue sous la seconde électrode E2 une barrière de potentiel BP1. Egalement durant cet intervalle de temps, la première impulsion de transfert ST1 est à l'état 1, de telle sorte que sous la première électrode E1 existe un potentiel VP1 de même valeur que sous les troisième et quatrième électrode E3, E4 et que des charges Q1, Q2 (représentées par des hachures sur la figure) peuvent être stockées sous ces électrodes en étant séparées par la barrière de potentiel BP1. Ainsi le puits de potentiel PU1 est constitué entre la barrière de potentiel BP1 formée sous la seconde électrode E2 et entre une seconde barrière de potentiel BP2 formée sous l'électrode de sortie ES par l'application du potentiel VES à cette électrode de sortie ; la valeur du potentiel VES étant telle qu'elle engendre sous l'électrode ES un potentiel VP3 compris entre les potentiels VP1 et VP2 et qui constitue la barrière de potentiel BP2.

Toujours entre les instants t8 et t9, au niveau de la diode de lecture 12a à potentiel flottant, c'est-à-dire sous la zone 12 dopée de type n+, le potentiel à une valeur VP4 voisine d'une valeur VP5 engendrée sous la seconde zone 13 dopée N+ par l'application de la tension d'alimentation VDR. Entre ces deux zones 12, 13 dopées N+, la grille de commande GC reçoit l'état zéro (potentiel négatif) de l'impulsion de remise à niveau SRN, cette impulsion de remise à niveau s'étant achevée à l'instant t8 : il en résulte que le potentiel sous l'électrode de commande GC est plus négatif que sous les zones 12, 13, et comporte par exemple une valeur VP2 de sorte à constituer sous cette grille de commande, une troisième barrière de potentiel BP3 qui sépare la région portée au potentiel VPS (région située sous la seconde zone 13) du puits de potentiel PU2 formé sous la première zone 12 et qui symbolise la diode de lecture 12a.

Le potentiel VP4 sous la première zone 12, c'est-à-dire au niveau de la diode de lecture 12a, est sensiblement celui qui est appliqué à l'entrée de l'amplificateur 16 quand aucune charge n'est transférée sur la diode de lecture 12a, il correspond sensiblement à la valeur VST du signal de sortie, et constitue le fond du puits de potentiel PU2 dans lequel les charges seront déversées ; ce déversement des charges modifie le potentiel appliqué à l'entrée de l'amplificateur de sortie 16 et détermine les variations d'amplitude du signal de sortie Ss que délivre ce dernier.

Entre le potentiel VP4 du fond du puits de potentiel PU2 et le potentiel VP3 de la seconde barrière BP2, est constituée une différence de potentiel DVL qui représente la dynamique maximale disponible sur la diode de lecture, et qui correspond par conséquent à la quantité maximale de charges qui peuvent être stockées dans le puits de potentiel PU2. Ainsi cette différence de potentiel de lecture DVL doit permettre d'accueillir la charge maximale pouvant être véhiculée par le registre à décalage RD, afin de ne pas limiter la dynamique de ce dernier.

La figure 3b illustre les profils de potentiels qui sont engendrés sous des électrodes de la structure montrée à la figure 3, entre les instants t9 et t10. A l'instant t9, le troisième signal de transfert ST3 passe à l'état 0, d'où il résulte : qu'une quatrième barrière de potentiels BP4 est formée sous la troisième électrode E3, cette quatrième barrière de potentiels BP4 prolonge la première barrière de potentiel BP1 ce qui a pour effet d'une part, de transformer le puits de potentiel PU1 montré en figure 3a en un puits de potentiel PU1' de plus faible surface formée uniquement sous la quatrième électrode E4, de telle sorte que la quantité de charges Q1 qui était précédemment stockée dans le puits de potentiel PU1 formé sous les deux électrodes E3, E4 doit se retrouver dans le puits de potentiel PU1' formé uniquement sous la quatrième électrode E4.

Dans ces conditions, lorsque la quantité de charges Q1 est suffisamment importante, elle peut excéder la capacité de stockage du puits de potentiel PU1', cette capacité de stockage étant limitée par la hauteur de la seconde barrière de potentiels BP2, c'est-à-dire par la valeur du potentiel VP3 ; dans ce cas où la quantité de charges Q1 est importante, une partie Q1a déborde par dessus la seconde barrière de potentiel BP2 (formée sous l'électrode de sortie ES), et arrive ainsi sur la diode de lecture ; une partie restante Q1b restant stockée dans le puits de potentiel PU1' formée sous la quatrième électrode E4. Ce transfert sur la diode de lecture de la partie Q1a des charges engendre la variation précédemment mentionnée du signal de sortie Ss qui passe de la valeur VSt à la valeur VS1 ; cette variation ayant été citée comme susceptible de constituer un inconvénient important dans le cas d'une lecture par méthode différentielle.

La figure 3c illustre le profil des potentiels pour la structure de la figure 3, entre l'instant t10 et l'instant t11 montrés aux figures 2.

A l'instant t10, le quatrième signal de transfert ST4 appliqué à la quatrième électrode E4 passe de l'état 1 à l'état zéro, d'où il résulte que sous la quatrième électrode E4 le puits de potentiel PU1' (représenté en traits pointillés) est remplacé par une cinquième barrière de potentiel BP5 adjacente à la quatrième barrière BP4, de telle sorte que la quantité de charges QU1b précédemment stockée sous la quatrième électrode E4 (PU1') est transférée sur la diode de lecture c'est-à-dire dans le puits de potentiel PU2. Le sommet de la cinquième barrière de potentiel BP5 est constitué par exemple par le potentiel VP2 qui forme également les barrières de potentiel BP1, BP3, BP4.

Il est à noter qu'entre le sommet de la seconde barrière de potentiel BP2 c'est-à-dire du potentiel VP3, et entre le sommet de la cinquième barrière de potentiel BP5 c'est-à-dire le potentiel VP2, il doit exister un écart de potentiel ou différence DV1 suffisamment important pour que les charges qui étaient stockées sous la quatrième électrode E4 soient transférées sur la diode de lecture avant que la cinquième barrière de potentiel BP5 (sous l'électrode E4) n'atteigne la valeur VP2 : en effet si la différence DV1 est trop faible, certaines des charges qui étaient contenues sous la quatrième électrode E4 peuvent revenir en arrière, c'est-à-dire vers un puits de potentiel PU6 formé sous la seconde électrode E2 au lieu d'être transférées sur la diode de lecture, ce qui tend à dégrader l'efficacité de transfert du registre RD.

Dans l'art connu, la différence de potentiel DV1 est obtenue en augmentant significativement (en rendant plus positif encore) le potentiel VES appliqué à l'électrode de sortie ES. Mais ceci peut avoir pour conséquence de réduire la dynamique de lecture et, afin de conserver une dynamique de lecture suffisante c'est-à-dire une différence de potentiel de lecture DVL suffisante, il est alors nécessaire d'avoir recours à une solution désavantageuse qui consiste à augmenter la tension VDR (pour la rendre plus positive) qui sert à effectuer la remise à niveau de la diode de lecture. Il en résulte comme inconvénient de voir augmenter toutes les tensions utiles au fonctionnement de l'étage de sortie : la tension VES appliquée à l'électrode de sortie, la tension VDR appliquée à la seconde zone 13 dopée N+ et la tension VDD d'alimentation de l'amplificateur de sortie 16.

La présente invention s'applique à un registre de lecture de type semblable à celui ci-dessus décrit, et elle a pour objet notamment d'accroître la dynamique de lecture de sortie sans présenter les inconvénients ci-dessus mentionnés. L'invention a également pour objet de permettre des lectures en sortie à l'aide de méthodes différentielles sans entacher cette méthode d'une erreur due à un transfert parasite des charges sur la diode de lecture, c'est-à-dire un transfert en deux temps.

L'invention concerne un registre de lecture tel que défini dans la revendication 1.

L'invention sera mieux comprise à l'aide de la description qui suit faite à titre d'exemple non limitatif, et aux 6 figures annexées parmi lesquelles :
- la figure 1 déjà décrite montre partiellement un registre de lecture de l'art antérieur ;
- les figures 2a à 2e déjà décrites représentent les signaux appliqués à des électrodes montrées à la figure 1 et la figure 2f représente les signaux en sortie d'un amplificateur de sortie montré à la figure 1 ;
- les figures 3 et 3a à 3c déjà décrites illustrent le fonctionnement de la structure représentée à la figure 1 ;
- la figure 4 est une vue en coupe semblable à la figure 1, et montre de manière partielle un registre de lecture conforme à l'invention ;
- les figures 5a à 5g constituent un chronogramme qui montre les relations des phases entre, des signaux appliqués à des électrodes montrées à la figure 4 et, un signal de sortie délivré par un amplificateur de sortie représenté à la figure 4 ;
- les figures 6 et 6a à 6c illustrent des profils de potentiels engendrés dans le substrat de la structure de l'invention montrée à la figure 4.

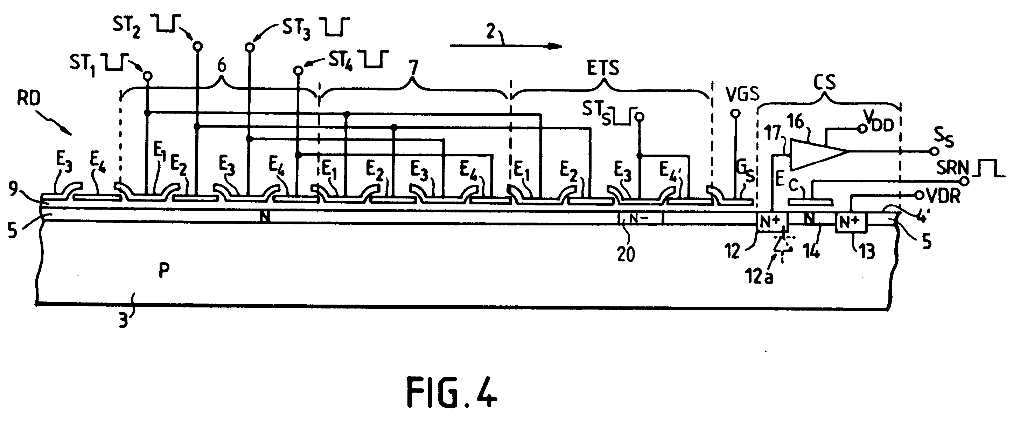

La figure 4 représente de manière schématique un registre de lecture RL selon l'invention.

Le registre de lecture RL comporte un registre à décalage RD qui, pour plus de clarté de la description, est du type fonctionnant en mode quatre phases c'est-à-dire avec quatre électrodes par étage de transfert comme dans le cas de la figure 1, de telle sorte que les différences qui apparaissent entre le registre de lecture de la figure 1 et le registre de lecture RL conformes à l'invention montré à la figure 4 portent uniquement sur l'invention.

Comme dans l'art antérieur, le registre de lecture RL comporte un substrat 3, dopé de type P par exemple avec une couche 5 dopée de type N destinée à former un canal enterré. Au dessus du canal enterré 5 est déposée une couche électriquement isolante 9 sur laquelle sont déposées des électrodes qui constituent un registre à décalage RD du type à transfert de charges ; le registre à décalage RD sert à transférer les charges dans le sens de transfert représenté par la flèche 2 vers un circuit de sortie CS.

Comme dans l'art antérieur, le circuit de sortie CS comporte :
- un amplificateur de sortie 16 alimenté par une tension d'alimentation V_{DD}, et qui délivre un signal de sortie Ss ;
- une première zone 12 dopée N+ en vue de constituer un élément de stockage terminal de charges c'est-à-dire dans l'exemple en vue de constituer une diode de lecture 12a ;
- une seconde zone 13 dopée N+ qui est reliée à la tension VDR de remise à niveau, et qui est séparée de la première zone 12 par une partie 14 du canal enterré 5 ;
- une électrode de commande EC située au dessus de la partie 18 qui est elle-même disposée entre les première et seconde zones 12, 13, cette électrode de commande EC recevant un signal de commande de remise à niveau SRN ;
- la première zone 12 dopée N+ étant comme dans l'art antérieur reliée à l'entrée 17 de l'amplificateur de sortie 16.

Comme dans l'art antérieur également, le circuit de sortie CS est séparé du registre à décalage ou plus précisément de l'étage de transfert dont il est le plus proche par une électrode ou grille de sortie GS à laquelle est appliqué un potentiel VGS destiné à former sous cette grille de sortie une barrière de potentiel de séparation.

Selon une caractéristique de l'invention, parmi les étages de transfert qui constituent le registre à décalage RD, l'étage de transfert qui est le plus proche de la grille de sortie GS c'est-à-dire le dernier étage de transfert ou étage de transfert de sortie ETS, comporte deux électrodes successives E3', E4' reliées entre elles de sorte à recevoir des mêmes impulsions de tensions cycliques appelées signaux de transfert de sortie STS afin d'être commandées simultanément dans le même sens, et ceci quel que soit le nombre d'électrodes que comporte cet étage de transfert de sortie ETS ; ces deux électrodes E3', E4' reliées entre elles sont les deux électrodes les plus proches de la grille de sortie GS c'est-à-dire les deux dernières électrodes dans le sens 2 de transfert des charges. Ainsi en observant la structure de la figure 4 en partant du circuit de sortie CS, selon un sens contraire au sens de transfert des charges, on trouve successivement : la grille de sortie GS ; puis les électrodes qui appartiennent à l'étage de sortie ETS c'est-à-dire d'abord la dernière ou quatrième électrode E4', et ensuite l'avant dernière ou troisième électrode E3' ; ces deux électrodes étant reliées ensemble ; on trouve ensuite la seconde électrode E2, suivie de la première électrode E1 qui appartiennent également à l'étage de sortie ETS ; on trouve ensuite comme dans l'art antérieur une succession d'étages de transfert 7, 6 classiques dont seulement deux ont été représentés pour simplifier la figure, avec quatre électrodes E4, E3, E2, E1 par étage de transferts 6, 7, ; toutes les électrodes d'un même rang étant reliées entre elles de manière à recevoir des impulsions de transferts ST1 à ST4 ayant une même phase comme il a été expliqué précédemment, c'est-à-dire que toutes les électrodes E1 sont reliées entre elles et reçoivent le premier signal de transfert ST1, les secondes électrodes E2 sont toutes reliées entre elles et reçoivent le second signal du transfert ST2, etc...

Dans l'exemple non limitatif de la description, où les étages de transferts 6, 7 sont à quatre électrodes chacun, l'étage de transfert de sortie ETS de l'invention est également réalisé sur la base d'une structure à quatre électrodes mais il pourrait en comporter davantage ou n'en comporter que trois. Dans l'exemple non limitatif décrit, la première et la seconde électrodes E1, E2 de l'étage de transfert de sortie sont reliées respectivement aux autres électrodes E1 et E2.

Dans cette configuration, la troisième et la quatrième électrodes E3', E4' de l'étage de transfert de sortie ETS sont actionnées simultanément et, selon une autre caractéristique de l'invention, la troisième électrode E3' comporte une compensation en tension, à l'aide d'une dose de bore par exemple (d'une manière en elle-même conventionnelle), c'est-à-dire que sous cette électrode E3' la couche enterrée 5 comporte une zone 20 dopée N-, c'est-à-dire du même type de conductivité que la couche enterrée 5 mais moins dopée que cette dernière. Ainsi l'électrode E3' qui constitue la première des deux électrodes reliées ensemble (dans le sens de transfert des charges) forme l'équivalent d'une électrode de transfert en mode biphasé, de manière que les potentiels engendrés sous ces deux électrodes E3', E4' aient des niveaux différents qui permettent le transfert des charges vers le circuit de sortie CS et s'opposent à ce transfert dans le sens opposé.

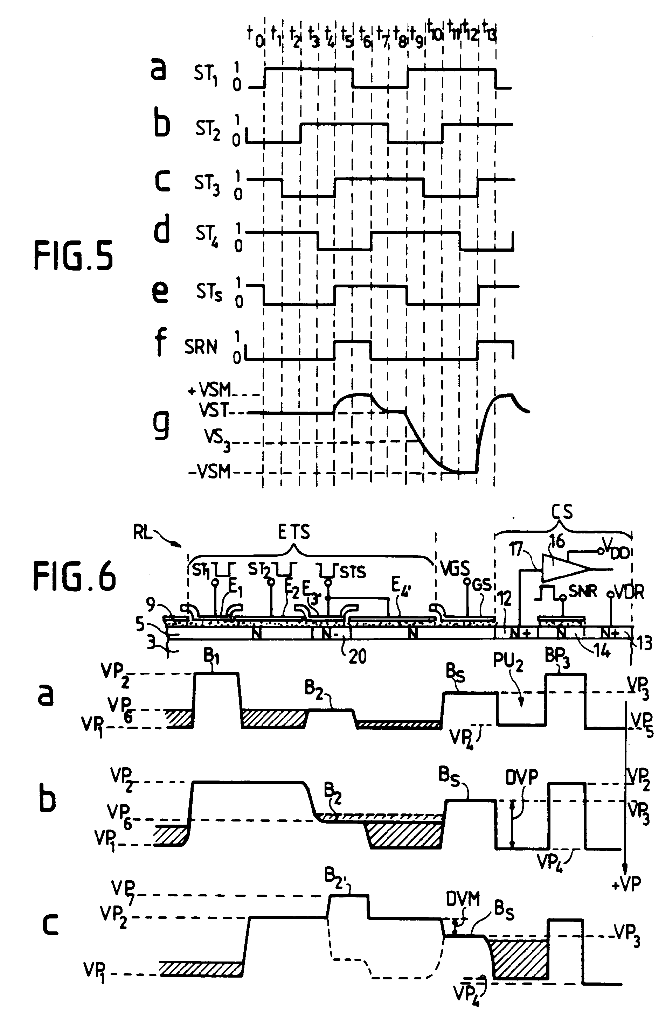

Les figures 5a à 5f montrent à titre d'exemple non limitatif les signaux à appliquer au registre de lecture RL selon l'invention, et la figure 5g illustre les variations qui en résultent du signal de sortie Ss.

La figure 5a représente les signaux de transfert ST1 appliqués à toutes les premières électrodes E1. La figure 5b montre les seconds signaux de transfert ST2 appliqués à toutes les électrodes E2. La figure 5c montre les troisièmes signaux de transfert ST3 appliqués à toutes les troisièmes électrodes E3. La figure 5d représente les quatrièmes signaux de transfert ST4 appliqués à toutes les électrodes E4. La figure 5e représente les signaux de transfert de sortie STS appliqués simultanément aux électrodes E3' et E4' appartenant à l'étage de transfert de sortie ETS. La figure 5f représente les signaux de remise à niveau SRN appliqués à l'électrode de commande EC. La figure 5g illustre les variations du signal de sortie Ss à la sortie de l'amplificateur de sortie 16.

A l'instant t0 : la première impulsion de transfert ST1 passe de l'état zéro à l'étage 1 (potentiel plus positif) ; le signal de transfert de sortie STS passe de l'état 1 à l'état zéro (potentiel plus négatif) ; le signal de sortie Ss est à la valeur de stabilisation VST.

A l'instant t1 : la troisième impulsion de transfert ST3 passe de l'état 1 à l'état zéro.

A l'instant t2 : la seconde impulsion de transfert ST2 passe de l'état zéro à l'état 1.

A l'instant t3 : la quatrième impulsion de transfert ST4 passe de l'état 1 à l'état zéro.

A l'instant t4 : le troisième signal de transfert ST3 passe à l'état 1 ; le signal de transfert de sortie STS passe de l'état zéro à l'état 1; le signal de remise à zéro SRN passe de l'état zéro à l'état 1 afin de commander la remise à niveau du signal de sortie Ss ; le signal de sortie Ss est alors encore à la valeur de stabilisation VST (en supposant qu'aucune charge n'ait été transférée) et il tend, à partir de l'instant t4, vers la valeur positive maximum +VSM qui correspond à l'application de la tension d'alimentation VDR.

A l'instant t5 : la première impulsion de transfert ST1 passe de l'état 1 à l'état zéro ; le signal de sortie Ss a atteint la valeur positive maximum +VSM.

A l'instant t6 : la quatrième impulsion de transfert ST4 passe de l'état zéro à l'état 1 ; le signal de remise à niveau SRN passe de l'état 1 à l'état zéro ; le signal de sortie Ss tend vers la valeur de stabilisation VST.

A l'instant t7 : la seconde impulsion de transfert ST2 passe de l'état 1 à l'état zéro ; le signal de sortie Ss a retrouvé la valeur de stabilisation.

A l'instant t8 : la première impulsion de transfert ST1 passe de l'état zéro à l'état 1 ; le signal de transfert de sortie STS passe de l'état 1 à l'état zéro, ce qui peut provoquer un transfert de charges sur la diode de lecture 12a et par suite engendrer une variation négative du signal de sortie Ss.

A l'instant t9 : le troisième signal de transfert ST3 passe de l'état 1 à l'état zéro ; en supposant qu'il y ait eu un transfert de charges sur la diode de lecture à partir de l'instant t8, le signal de sortie Ss est, à l'instant t9, à une valeur VS3 comprise entre la valeur de stabilisation VST et une valeur négative maximum -VSM que peut avoir le signal de sortie Ss quand une quantité maximum de charges est transférée sur la diode de lecture 12a.

A l'instant t10 : la seconde impulsion de transfert ST2 passe de l'état zéro à l'état 1.

A l'instant t11 : la quatrième impulsion de transfert ST4 passe de l'état 1 à l'état zéro ; et en supposant que le maximum de charges ait été transféré sur la diode de lecture 12a, le signal de sortie Ss est à une valeur voisine de la valeur -VSM.

A l'instant t12 : le troisième signal de transfert ST3 passe de l'état zéro à l'état 1 ; le signal de transfert de sortie STS passe de l'état zéro à l'état 1, ce qui marque la fin du transfert sur la diode de lecture des charges qui étaient contenues sous les troisième et quatrième électrodes E3', E4' (reliées ensemble) de l'étage de transfert de sortie ; le signal de remise à niveau SRN passe de l'état zéro à l'état 1 de manière à commander la remise à niveau de la diode de lecture ; le signal de sortie est à la valeur négative maximum -VSM, et à partir de l'instant t12 va tendre vers la valeur positive maximum +VSM (du fait de la commande de la remise à niveau qui débute à partir de l'instant t12).

Ce fonctionnement est répété de manière cyclique et semblable à celle qui vient d'être décrite.

Il est à noter que le signal de transfert de sortie STS appliqué aux deux électrodes E3', E4' reliées ensemble a un rapport cyclique sensiblement égal à un, ce qui peut permettre une symétrie des durées de temps allouées à la phase de remise à niveau de la diode de lecture et à la phase d'arrivée des charges sur cette dernière. On peut remarquer en outre que du fait de la commande simultanée et dans le même sens des deux électrodes E3' et E4', l'arrivée des charges sur la diode de lecture est obtenue en une seule fois, ce qui permet notamment d'augmenter le temps pendant lequel le signal de sortie Ss est à la valeur de stabilisation VST, entre l'instant t7 et l'instant t8 par exemple ce qui autorise une lecture par une méthode différentielle de manière simple et précise.

La figure 6 est une vue schématique en coupe qui montre le registre de lecture d'une manière semblable à celle de la figure 4, mais où le registre à décalage RD est représenté uniquement par l'étage de transfert de sortie ETS pour simplifier la description.

Les figures 6a, 6b, 6c sont à lire chacune en même temps que la figure 6 et illustrent le profil des potentiels qui sont établis notamment sous les différentes électrodes de l'étage de transfert de sortie ETS et sous la grille de sortie GS.

La figure 6a montre les profils de potentiels qui existent dans le substrat 3 entre l'instant t5 et l'instant t7 des figures 5.

La première impulsion de transfert ST1 venant de passer de l'état 1 à l'état zéro, le potentiel sous la première électrode E1 est plutôt négatif, à la valeur VP2 par exemple et constitue une barrière de potentiel B1. La seconde impulsion de transfert ST2 et l'impulsion de transfert de sortie STS sont alors a l'état 1 et engendrent sous les électrodes correspondantes des potentiels plutôt positifs, c'est-à-dire sous la seconde électrode E2, un potentiel VP1, et également un potentiel VP1 sous la quatrième ou dernière électrode E4' de la paire d'électrodes E3', E4' qui sont reliées entre elles ; par contre, compte-tenu du dopage un peu différent réalisé sous la troisième ou avant dernière électrode E3' (comme il a été précédemment mentionné), il existe un seuil de potentiel entre l'électrode E3' et l'électrode E4' tel, que sous l'électrode E3' il est créé un potentiel VP6 négatif par rapport au potentiel VP1 et positif par rapport au potentiel VP2, et qui permet de réaliser entre la seconde electrode E2 et la dernière électrode E4', une barrière de potentiels B2 de faible niveau. La tension VGS appliquée à la grille de sortie Gs détermine sous cette dernière le potentiel VP3 qui réalise sous la grille de sortie Gs la barrière de potentiel de séparation BS ; il est à remarquer que la seconde barrière de potentiels B2 est moins élevée que la barrière de potentiels de séparation BS c'est-à-dire que le potentiel VP6 sous la troisième électrode E3' est plus positif que le potentiel VP3 sous la grille de sortie GS. L'impulsion de remise à niveau SRN est à l'état zéro, de sorte que sous l'électrode de commande EC du circuit de sortie CS on trouve le potentiel négatif VP2 qui détermine sous cette électrode la barrière de potentiel BP3 ; cette barrière de potentiel BP3 réalise une séparation entre le potentiel VPS qui existe sous la seconde zone 13 dopée N+ et entre le puits de potentiel PU2 qui existe sous la première zone 12 dopée N+ et dont le fond est au potentiel VP4.

A l'instant t5, la première impulsion de transfert est passée de l'état 1 à l'état zéro, ce qui a eu pour effet de déverser sous la seconde électrode E2 les charges qui étaient précédemment stockées sous la première électrode E1 (les charges sont représentées en traits hachurés) et si la quantité de charges était importante, certaines de ces charges peuvent déborder par dessus la seconde barrière B2 (sous l'avant dernière électrode E3') et être accumulées sous la dernière électrode E4'.

La figure 6b illustre le fonctionnement et le profil des potentiels entre l'instant t7 et l'instant t8 : lorsqu'à l'instant t7 la seconde impulsion de transfert ST2 passe de l'état 1 à l'état zéro, le potentiel sous la seconde électrode E2 passe de la valeur VP1 à la valeur plus négative VP2, et toutes les charges qui étaient stockées sous la seconde électrode E2 sont transférées sous la dernière et quatrième électrodes E4'; aucune de ces charges ne peut déborder par dessus la barrière de séparation BS dont le potentiel VP3 est à cet effet suffisamment négatif, le potentiel VP3 étant plus positif que le potentiel VP2 et plus négatif que le potentiel VP6 qui forme la seconde barrière de potentiel B2 due au seuil de potentiel que présente la troisième ou avant dernière électrode E3', de telle sorte qu'à la limite, si la quantité de charges transférées sous l'avant dernière électrode E4' était très importante, elle pourrait déborder au dessus de la seconde barrière B2.

On remarque que par rapport à l'art antérieur, aucune charge n'a été transférée sur la diode de lecture, c'est-à-dire dans le second puits de potentiel PU2 formé sous la première zone 12, et que l'entière différence de potentiel DVP (formée par la différence entre le potentiel VP3 de la barrière BS et le potentiel VP4 du fond de puits PU2) reste disponible pour stocker des charges sur la diode de lecture 12a.

La figure 6c illustre le fonctionnement et le profil des potentiels qui existent entre l'instant t8 et l'instant t12 : a l'instant t8, l'impulsion de transfert de sortie STS passe de l'état 1 à l'état zéro ce qui entraîne une variation négative des potentiels sous les dernière et avant dernière électrodes E4', E3', c'est-à-dire sous les paires d'électrodes reliées entre elles : il en résulte que toutes les charges stockées sous la dernière électrode E4' et éventuellement sous l'avant dernière électrode E3' sont transférées sur la diode de lecture, c'est-à-dire dans le second puits de potentiel PU2.

Le passage de l'état 1 à l'état zéro de l'impulsion de transfert de sortie STS a modifié les valeurs de potentiels sous les deux dernières électrodes E3', E4' tout en conservant la forme générale (montrée en traits pointillés) qui existaient avant l'instant t8 : en effet d'une part, sous la dernière électrode E4', le potentiel est passé à la valeur VP2 qui est plus négative que la valeur VP3 de la barrière de séparation BS formée sous la grille de sortie GS ; et d'autre part, le potentiel sous l'avant dernière ou troisième électrode E3' est passé à une valeur VP7 plus négative que la valeur VP2, c'est-à-dire que le seuil de potentiel (formant précédemment la barrière B2) qui existait précédemment entre les régions correspondant à la troisième ou avant dernière électrode E3' et la quatrième ou dernière électrode E4' est conservé (seuil de potentiel obtenu à l'aide de la compensation précédemment mentionnée) de sorte que ces seuils de potentiels constituent maintenant une nouvelle barrière de potentiels B2' qui permet d'interdire tous retours de charges en arrière et assure ainsi une bonne efficacité de transfert.

Il est à noter également que le potentiel VGS, appliqué à l'électrode de sortie GS est juste suffisant pour que le potentiel VP3 engendré sous l'électrode GS soit un peu plus positif que le potentiel VP2 afin de réaliser une marche de potentiel DVM (DVM pouvant être par exemple de l'ordre de 1 à 2 volts) qui permet le passage des charges depuis la dernière électrode ou quatrième électrode E4' vers la diode de lecture flottante 12a représentée ici par le puits de potentiel PU2.

La dynamique de sortie est ainsi maximale sans qu'il soit nécessaire d'augmenter les tensions VGS, VDR, VDD.

Cette description constitue un exemple non limitatif qui montre comment améliorer la précision de lecture et comment augmenter la dynamique de sortie de lecture de tous registres de lecture de type à transfert de charges, fonctionnant en modes autres que biphasé. Bien entendu l'invention peut s'appliquer à des structures différentes, par exemple avec canal enterré ou non, et également la technologie employée peut être différente par exemple à deux niveaux ou plus de silicium polycristallin. Il est également possible de modifier la position relative des signaux appliqués aux registres à décalage et aux circuits de sortie tout en restant dans le cadre de l'invention.

## Revendications

1. Registre de lecture comportant, un substrat semiconducteur (3), un registre à décalage (RD) à transfert de charges formé d'une succession d'étages de transfert (6,7, ETS), un circuit de sortie (CS) disposé à proximité du dernier étage de transfert (ETS) dans le sens (2) de transfert des charges, chaque étage de transfert (6,7, ETS) comportant au moins trois électrodes indépendantes les unes des autres auxquelles sont appliquées des impulsions de tensions cycliques constituant des impulsions de transfert (ST1, ST2, ST3, ST4) ayant des phases différentes pour chaque électrode d'un même étage de transfert, de manière à engendrer dans le substrat (3) des puits et des barrières de potentiels (PU2, B1, B2, B3) servant à transférer les charges vers le circuit de sortie (CS), le circuit de sortie (CS) comportant un élément terminal (12a) de stockage de charges formant dans le substrat (3) une zone à potentiel flottant (12), la zone (12) à potentiel flottant étant reliée à un amplificateur de lecture (16), l'élément terminal de stockage de charges (12a) étant séparé du dernier étage de transfert (ETS) par une grille de sortie (GS) sous laquelle est formée une barrière de potentiels de séparation (BS), caractérisé en ce que dans le dernier étage de transfert (ETS) deux électrodes successives (E3', E4') les plus proches de la grille de séparation (GS) sont reliées entre elles et sont commandées par une même impulsion de transfert de sortie (STS), ces deux electrodes reliées entre elles formant l'avant dernière et la dernière électrode de l'étage de transfert de sortie (ETS) dans le sens (2) de transfert des charges.

2. Registre de lecture selon la revendication 1, caractérisé en ce qu'il comporte des moyens (20) pour engendrer sous ladite avant dernière électrode (E3') une barrière de potentiel (B2, B2') par rapport au potentiel engendré sous la dernière électrode (E4').

3. Registre de lecture selon la revendication 2, caractérisé en ce que sous l'avant dernière électrode (E3') est formée une zone (20) dopée d'un même type de conductivité (N-) que sous la dernière électrode (E4') mais moins fortement dopée que sous cette dernière.

4. Registre de lecture selon l'une des revendications précédentes, caractérisé en ce que la barrière de potentiel de séparation (BS) formée sous la grille de sortie (GS) est à un potentiel (VP3) compris entre, un potentiel (VP2) établi sous la dernière électrode (E4') quand les charges sont transférées sur l'élément de stockage terminal (12a), et entre un potentiel (VP6) établi sous l'avant dernière électrode (E3') quand des charges sont susceptibles d'être stockées sous la dernière électrode (E4').

## Patentansprüche

1. Leseregister mit einem Halbleitersubstrat (3), einem Ladungsübertragungs-Schieberegister (RD), das aus einer Folge von Übertragungsstufen (6, 7, ETS) besteht, einer Ausgangsschaltung (CS), die in der Nähe der letzten Übertragungsstufe (ETS) in der Ladungsübertragungsrichtung (2) angeordnet ist, wobei jede Übertragungsstufe (6, 7, ETS) wenigstens drei voneinander unabhängige Elektroden aufweist, an die zyklische Spannungsimpulse angelegt werden, die Übertragungsimpulse (ST1, ST2, ST3, ST4) mit für jede Elektrode der gleichen Übertragungsstufe unterschiedlichen Phasen bilden, so daß in dem Substrat (3) Potentialsenken und -barrieren (PU2, B1, B2, B3) erzeugt werden, die dazu dienen, die Ladungen zu der Ausgangsschaltung (CS) zu übertragen, wobei die Ausgangsschaltung (CS) ein Ladungsspeicher-Anschlußelement (12a) aufweist, das in dem Substrat (3) eine Zone (12) mit schwimmendem Potential erzeugt, wobei die Zone (12) mit schwimmendem Potential an einen Leseverstärker (16) angeschlossen ist, wobei das Ladungsspeicheranschlußelement (12a) von der letzten Übertragungsstufe (ETS) durch ein Ausgangs-Gate (GS) getrennt ist, unter dem eine Trenn-Potentialbarriere (BS) gebildet wird, dadurch gekennzeichnet, daß in der letzten Übertragungsstufe (ETS) zwei dem Trenn-Gate (GS) am nächsten liegende aufeinanderfolgende Elektroden (E3', E4') miteinander verbunden und durch den gleichen Ausgangsübertragungsimpuls (STS) gesteuert werden, wobei diese miteinander verbundenen Elektroden die vorletzte und die letzte Elektrode der Ausgangsübertragungsstufe (ETS) in der Ladungsübertragungsrichtung (2) bilden.

2. Leseregister nach Anspruch 1, dadurch gekennzeichnet, daß es Mittel (20) enthält, um unter der vorletzten Elektrode (E3') eine Potentialbarriere (B2, B2') bezüglich des unter der letzten Elektrode (E4') erzeugten Potentials zu erzeugen.

3. Leseregister nach Anspruch 2, dadurch gekennzeichnet, daß unter der vorletzten Elektrode (E3') eine dotierte Zone (20) vom gleichen Leitungstyp (N-) wie unter der letzten Elektrode (E4'), jedoch weniger stark dotiert als letztere, gebildet ist.

4. Leseregister nach einem der vorhergehenden Ansprüche, dadurch gekennzeichnet, daß die Trenn-Potentialbarriere (BS), die unter dem Ausgangs-Gate (GS) gebildet ist, ein Potential (VP3) hat, das zwischen einem Potential (VP2), das unter der letzten Elektrode (E4') vorliegt, wenn die Ladungen zum Ladungsspeicheranschluß (12a) übertragen werden, und einem Potential (VP6) liegt, das unter der vorletzten Elektrode (E3') vorliegt, wenn Ladungen unter der letzten Elektrode (E4') abspeicherbar sind.

## Claims

1. Read register comprising a semiconductor substrate (3), a charge-transfer shift register (RD), formed by a succession of transfer stages (6, 7, ETS), an output circuit (CS) arranged in proximity to the last transfer stage (ETS) in the direction (2) of transfer of the charges, each transfer stage (6, 7, ETS) including at least three electrodes which are independent of one another, to which are applied cyclic voltage pulses constituting transfer pulses (ST1, ST2, ST3, ST4) having different phases for each electrode of the same transfer stage, so as to generate, in the substrate (3), potential wells and barriers (PU2, B1, B2, B3) serving to transfer the charges towards the output circuit (CS), the output circuit (CS) including a terminal charge storage element (12a) forming, in the substrate (3), a region at floating potential (12), the region (12) at floating potential being linked to a read amplifier (16), the terminal charge storage element (12a) being separated from the last transfer stage (ETS) by an output gate (GS) under which is formed a separation potential barrier (BS), characterized in that, in the last transfer stage (ETS), two successive electrodes (E3', E4') which are closest to the separation gate (GS) are linked together and are controlled by the same output transfer pulse (STS), these two electrodes linked together forming the second last and the last electrode of the output transfer stage (ETS) in the direction (2) of charge transfer.

2. Read register according to Claim 1, characterized in that it includes means (20) for generating, under the said second-last electrode (E3'), a potential barrier (B2, B2') with respect to the potential generated under the last electrode (E4').

3. Read register according to Claim 2, characterized in that, under the second-last electrode (E3') a doped region (20) is formed with the same conductivity type (N-) as under the last electrode (E4') but less heavily doped than under the latter.

4. Read register according to one of the preceding claims, characterized in that the separation potential barrier (BS) formed under the output gate (GS) is at a potential (VP3) lying between a potential (VP2) set up under the last electrode (E4') when the charges are transferred onto the terminal storage element (12a), and between a potential (VP6) set up under the second-last electrode (E3') when charges can be stored under the last electrode (E4').
